Europäisches Patentamt

European Patent Office

Office européen des brevets

(19)

(11) Veröffentlichungsnummer: **0 014 961**

**A1**

(12) **EUROPÄISCHE PATENTANMELDUNG**

(21) Anmeldenummer: **80100742.8**

(22) Anmeldetag: **14.02.80**

(51) Int. Cl.³: **G 02 B 7/26**

(30) Priorität: **17.02.79 DE 2906227**

(43) Veröffentlichungstag der Anmeldung:
**03.09.80 Patentblatt 80/18**

(84) Benannte Vertragsstaaten:
**AT BE CH FR GB IT LU NL SE**

(71) Anmelder: **HARTING ELEKTRONIK GmbH**
**Postfach 1140**
**D-4992 Espelkamp(DE)**

(72) Erfinder: **Fischbach, Jörn-Uwe, Dr.**
**Leuschnerstrasse 40**
**D-6457 Maintal 1(DE)**

(72) Erfinder: **Brunsmann, Ulrich, Dr.**
**Vorderste Weide 23**
**D-6350 Bad Nauheim(DE)**

(72) Erfinder: **Nagel, Hans**
**Untkenbeeke 1**
**D-4952 Porta-Westfalica(DE)**

(74) Vertreter: **Blum, Klaus-Dieter, Dipl.-Ing.**
**Am Römerhof 35**
**D-6000 Frankfurt/Main 90(DE)**

(54) **Verfahren und Vorrichtung zur Ankopplung von elektro-optischen Wandlern an Lichtwellenleiter.**

(57) Zur Ankopplung von elektro-optischen Wandlern an Lichtwellenleiter wird ein konkav gekrümmter Reflektor (7) verwendet, der durch Drehung um seine Achse und/oder durch Verschiebung in radialer Richtung gegenüber einer Sockeleinheit (2) justierbar ist. Durch die Sockeleinheit (2), die den elektro-optischen Wandler (1) trägt, wird der Lichtwellenleiter (4) geführt.

Fig. 1

0014961

V-64.355-01/45/78

CASCH/SUK

14. Februar 1979/
29. Januar 1980

HARTING ELEKTRONIK GmbH, Espelkamp

======================================================

Verfahren und Vorrichtung zur Ankopplung von
elektro-optischen Wandlern an Lichtwellenleiter

======================================================

Die Erfindung bezieht sich auf ein Verfahren und eine Vorrichtung zur Ankopplung von elektro-optischen Wandlern an Lichtwellenleiter, wobei optische Signale mittels abbildender Systeme übertragen werden.

Bei der optischen Nachrichtenübertragung mittels Lichtwellenleitern müssen diese mit elektro-optischen Wandlern, wie Sender- und Empfängerdioden gekoppelt werden. Eine direkte Übertragung von Lichtenergie zwischen zwei solchen optischen Bauteilen ist mit erheblichen Übertragungsverlusten verbunden. Um einen hohen Ankopplungswirkungsgrad zu erhalten, müssen die von den Sendern emittierten Signale möglichst vollständig in die Lichtwellenleiter und an deren Ende möglichst vollständig in die Empfänger eingekoppelt werden.

Zur Lösung der hierbei auftretenden technologischen Probleme sind bereits einige Verfahren und Vorrichtungen bekannt. Einen Ausweg bietet z.B. die Verwendung von Lichtwellenleitern mit sphärisch gekrümmten Endflächen (Appl. Phys. 44, 6, 1973, S. 2756 ff). Die dadurch hervorgerufene Linsenwirkung ruft eine Vergrößerung des Aperturwinkels der Faser hervor. Die Linsen können durch Anschmelzen des Faserendes oder durch entsprechend belichtete und geätzte Fotolacke hergestellt werden. Eine optisch fehlerfreie sphärisch gekrümmte Endfläche an einer Glasfaser ist jedoch schwer zu erzielen. Ein zu großer Teil des erzeugten Lichtes geht verloren , wenn z.B. die Krümmung der Linse beim Anschmelzvorgang sehr groß wird. Andere Lösungen sind sehr aufwendig, insbesondere, wenn eine genaue Justierung der nur ca. 100 $\mu$m großen Linse erforderlich ist.

Der vorliegenden Erfindung liegt daher die Aufgabe zugrunde, die o.g. Nachteile zu überwinden und ein Verfahren bzw. eine Vorrichtung anzugeben, mit der eine effiziente Ankopplung von elektro-optischen Wandlern an Lichtwellenleiter ohne aufwendige Montage- und Justierarbeiten unter Vermeidung von Übertragungsverlusten ermöglicht wird.

Es hat sich gezeigt, daß sich diese Aufgabe in technisch fortschrittlicher Weise lösen läßt, wenn als abbildendes System ein konkav gekrümmter Reflektor verwendet wird und der Reflektor durch Drehung um seine Achse und/oder durch Verschiebung in radialer Richtung justiert wird. Die vorteilhaften Weiterbildungen des erfindungsgemäßen Verfahrens sind in den Unteransprüchen 2 bis 4 beschrieben.

Die erfindungsgemäße Vorrichtung ist dadurch gekennzeichnet, daß sie eine Sockeleinheit aufweist, die den elektro-optischen Wandler trägt und durch die der Lichtwellenleiter geführt ist, und daß ein Reflektorteil vorgesehen ist, das mit der konkav gekrümmten Fläche gegenüber der Sockeleinheit justierbar und fixierbar angeordnet ist. In den Ansprüchen 6 bis 10 sind einige vorteilhafte Ausführungsformen der erfindungsgemäßen Vorrichtung erläutert.

Im folgenden wird die Erfindung anhand von lediglich einen Ausführungsweg darstellenden Zeichnungen näher erläutert. Es zeigen in schematischer Vereinfachung

Figur 1    im Querschnitt die erfindungsgemäße Vorrichtung, bei der das Reflektorteil drehbar über der Sockeleinheit angeordnet ist und

Figur 2    eine weitere Ausführungsform, bei der die Justierung durch Drehung und radiale Verschiebung des Reflektorteils erzielt wird.

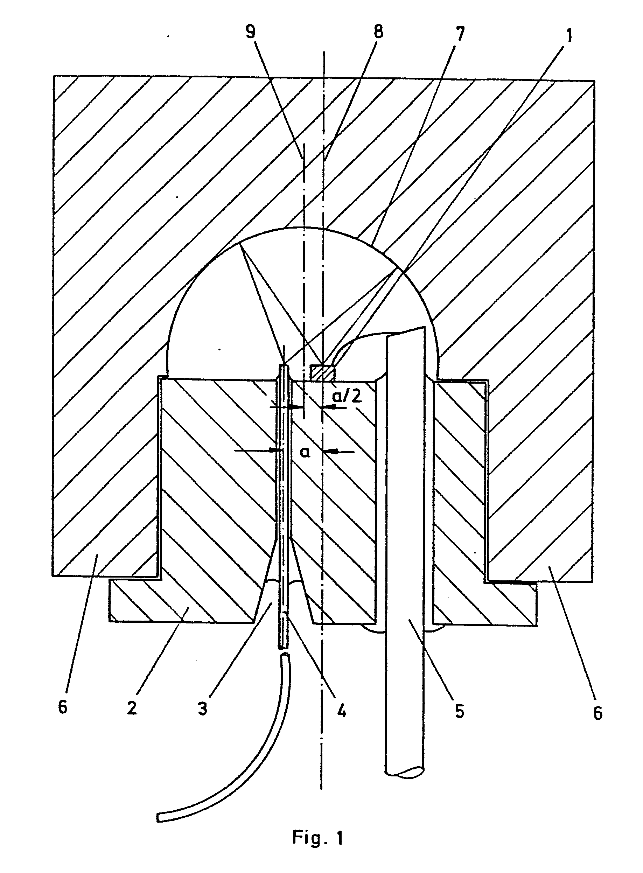

Bei der in Figur 1 gezeigten Vorrichtung befindet sich die Halbleiterdiode 1 auf einer Sockeleinheit 2. Sie kann einen handelsüblichen TO 18- oder TO 5-Sockel darstellen, bei dem die Diode etwa konzentrisch auf dem Sockel angeordnet ist und eine relativ große Fläche aufweist.

In dem Sockel 2 im Abstand a von dem Mittelpunkt der Diode 1 ist eine Bohrung 3 vorgesehen, durch die der Lichtwellenleiter 4 mit planem Ende geführt ist. Die Fixierung des Lichtwellenleiters 4 kann durch Verwendung eines geeigneten Klebstoffes erfolgen. Die Sockeleinheit 2 weist ferner die erforderlichen Versorgungsleitungen 5 auf.

Das Reflektorteil 6 hat eine konkave, der Diode bzw. dem Lichtwellenleiterende gegenüberstehende Fläche 7 und ist drehbar angeordnet. Die Drehachse 8 des Reflektorteils und die Reflektorachse 9, d.h. die Symetrieachse der reflektierenden konkaven Fläche 7, haben einen Abstand von a/2 voneinander, wobei die Drehachse 8 des Reflektorteils durch den Mittelpunkt der Diode 1 führt. Zur Justierung der Abbildung der Diode 1 auf das Ende des Lichtwellenleiters 4 wird das Reflektorteil 6 gedreht und anschließend relativ zu der Sockeleinheit 2 fixiert.

Der Abbildungsmaßstab kann durch Änderung des Abstands vom Lichtwellenleiterende bzw. der Oberfläche der Diode zur Fokal-

0014961

ebene festgelegt werden. Ferner kann der Durchmesser des Hohlspiegels oder die Entfernung der konkaven Fläche von der Sockel-einheit entsprechend ausgewählt werden.

Diese Anordnung eignet sich besonders zur Ankopplung handelsüblicher bereits auf Sockeln montierter lichtemittierender Dioden oder Laserdioden sowie Empfängerdioden, wie pin- bzw. Avalanche-Fotodioden.

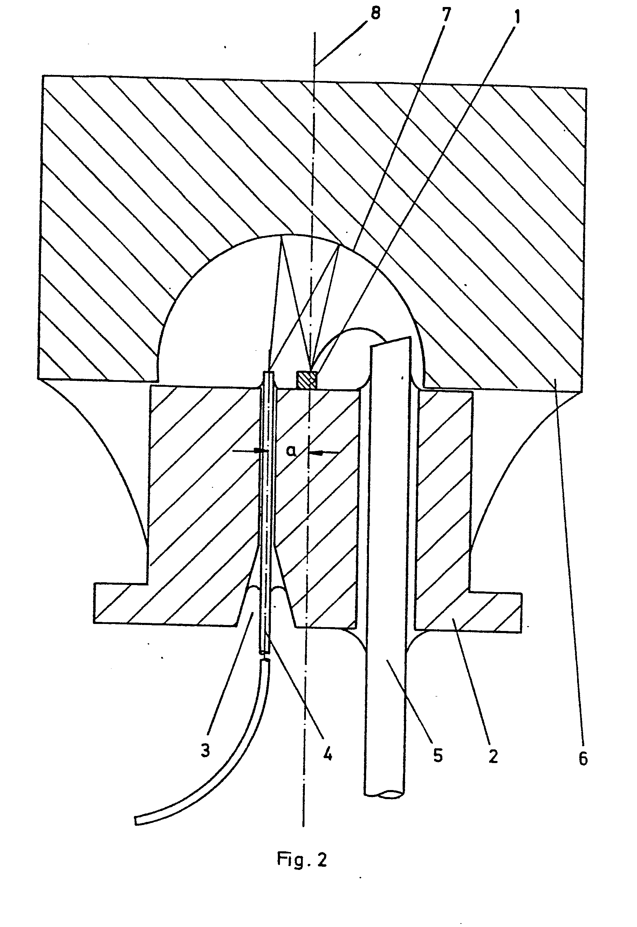

Wenn der elektro-optische Wandler nicht konzentrisch auf der Sockeleinheit angeordnet ist, so muß zur genauen Justierung das Reflektorteil drehbar und radial verschiebbar sein. Die in Figur 2 dargestellte Ausführungsform zeigt schematisch eine solche Vorrichtung.

Die Sockeleinheit 2 ist wie in der in Figur 1 dargestellten Ausführungsform aufgebaut. Der Abstand des Lichtwellenleiters von der Diode beträgt in diesem Fall $a - \Delta a$ bzw. schwankt um den ge-ringen Wert $\Delta a$. Das Reflektorteil 6 weist eine plane Unterseite auf, so daß es senkrecht zur Drehachse 8 um wenigstens $(a + \Delta a)/2$ verschiebbar ist. Da zur einwandfreien Justierung eine Drehung von nur einigen Grad notwendig ist, läßt sich diese Drehung auch durch eine zweite radiale Verschiebung, z.B. mittels Justierschrauben, senkrecht zu der ersten Verschiebung realisieren.

In beiden Fällen kann die reflektierende Fläche ein sphärisch oder parabolisch gekrümmter Spiegel sein. Der Hohlspiegeleindruck kann einfacherweise durch Einpressen einer Stahlkugel in einen geeigneten metallischen Formkörper hergestellt werden.

V-64.355-01/45/78

**CASCH/SUK**

14. Februar 1979/
29. Januar 1980

HARTING ELEKTRONIK GmbH, Espelkamp

<u>Patentansprüche</u>

1. Verfahren zur Ankopplung von elektro-optischen Wandlern an Lichtwellenleiter, bei dem optische Signale mittels abbildender Systeme übertragen werden, <u>dadurch gekennzeichnet</u>, daß als abbildendes System ein konkav gekrümmter Reflektor verwendet wird und daß der Reflektor durch Drehung um seine Achse und/oder durch Verschiebung in radialer Richtung justiert wird.

2. Verfahren nach Anspruch 1, <u>dadurch gekennzeichnet</u>, daß als Reflektor ein sphärisch oder parabolisch gekrümmter Spiegel verwendet wird.

3. Verfahren nach Anspruch 1 und 2, dadurch gekennzeichnet, daß der Abbildungsmaßstab durch Änderung des Abstandes vom Lichtwellenleiterende bzw. der Oberfläche des elektro-optischen Wandlers zur Fokalebene festgelegt wird.

4. Verfahren nach einem der Ansprüche 1 bis 3, dadurch gekennzeichnet, daß zur Erzielung einer genauen Justierung ein optisches Signal übergekoppelt wird und während der Drehung und radialen Verschiebung des Reflektors der Koppelwirkungsgrad bestimmt wird.

5. Vorrichtung zur Ankopplung von elektro-optischen Wandlern an Lichtwellenleiter, bei der abbildende Systeme zur Übertragung optischer Signale verwendet werden, dadurch gekennzeichnet, daß sie eine Sockeleinheit (2) aufweist, die den elektro-optischen Wandler (1) trägt und durch die der Lichtwellenleiter (4) geführt ist, und daß ein Reflektorteil (6) vorgesehen ist, das mit der konkav gekrümmten Fläche (7) gegenüber der Sockeleinheit (2) justierbar und fixierbar angeordnet ist.

6. Vorrichtung nach Anspruch 1, dadurch gekennzeichnet, daß die konkave Krümmung eine sphärische oder parabolische Spiegelfläche ist.

7. Vorrichtung nach Anspruch 5 und 6, dadurch gekennzeichnet, daß der Abstand zwischen der Drehachse des Reflektorteils (8) und der Reflektorachse (9) dem halben Abstand zwischen Lichtwellenleiterachse und Mittelpunkt des elektro-optischen Wandlers entspricht und daß die Drehachse des Reflektorteils (8) durch den Mittelpunkt des elektro-optischen Wandlers (1) führt oder mit der Lichtwellenleiterachse zusammenfällt und im justierten Zustand die Reflektorachse die Verbindungslinie des Mittelpunkts des elektro-optischen Wandlers (1) und des Mittelpunktes des Lichtwellenleiters (4) schneidet.

8. Vorrichtung nach Anspruch 5 und 6, dadurch gekennzeichnet, daß zur Justierung das Reflektorteil (6) auf der Sockeleinheit (2) radial verschiebbar angeordnet ist.

9. Vorrichtung nach einem der Ansprüche 5 - 8, dadurch gekennzeichnet, daß das Reflektorteil (6) nach der Justierung relativ zur Sockeleinheit (2) fixierbar ist.

10. Vorrichtung nach einem der Ansprüche 1 - 9, dadurch gekennzeichnet, daß die Oberfläche des elektro-optischen Wandlers (1) mit der Endfläche des Lichtwellenleiters (4) fluchtet.

Fig. 1

Fig. 2

0014961

**EUROPÄISCHER RECHERCHENBERICHT**

Europäisches
Patentamt

Nummer der Anmeldung

EP 80 10 0742

| EINSCHLÄGIGE DOKUMENTE | | | KLASSIFIKATION DER ANMELDUNG (Int.Cl.3) |
|---|---|---|---|
| Kategorie | Kennzeichnung des Dokuments mit Angabe, soweit erforderlich, der maßgeblichen Teile | betrifft Anspruch | |
| | IBM TECHNICAL DISCLOSURE BULLETIN, Band 21, Nr. 4, September 1978, New York E.G. LEAN "Taps for multimode fibers" Seite 1685 -- | 1,2 | G 02 B 7/26 |
| | DE - A1 - 2 747 773 (NORTHERN TELECOM LTD.) * Anspruch 1; Fig. 1 * -- | 4,8,9 | |
| A | DE - B - 2 159 327 (LICENTIA) * Fig. 1 * -- | 7 | RECHERCHIERTE SACHGEBIETE (Int. Cl.3) G 02 B 7/26 |
| A | US - A - 4 021 099 (B.S. KAWASAKI) * Fig. 9 * ---- | 1 | |

KATEGORIE DER GENANNTEN DOKUMENTE

X: von besonderer Bedeutung
A: technologischer Hintergrund
O: nichtschriftliche Offenbarung
P: Zwischenliteratur
T: der Erfindung zugrunde liegende Theorien oder Grundsätze
E: kollidierende Anmeldung
D: in der Anmeldung angeführtes Dokument
L: aus andern Gründen angeführtes Dokument
&: Mitglied der gleichen Patentfamilie, übereinstimmendes Dokument

X Der vorliegende Recherchenbericht wurde für alle Patentansprüche erstellt.

| Recherchenort | Abschlußdatum der Recherche | Prüfer |
|---|---|---|
| Berlin | 27-05-1980 | FUCHS |